# EUROPÄISCHE PATENTSCHRIFT

(11) **EP 1 314 210 B1**
(45) Veröffentlichungstag und Bekanntmachung des Hinweises auf die Patenterteilung: **01.12.2010**
(21) Anmeldenummer: 01960115.2
(22) Anmeldetag: 06.07.2001
(51) Int. Cl.: H01L 41/083, H01L 41/24

(54) **PIEZOAKTOR UND VERFAHREN ZUR HERSTELLUNG EINES PIEZOAKTORS**
PIEZOACTUATOR AND A METHOD FOR PRODUCING A PIEZOACTUATOR
ACTIONNEUR PIEZO-ELECTRIQUE ET SON PROCEDE DE PRODUCTION

(30) Priorität: 31.08.2000 DE 10042941
(43) Veröffentlichungstag der Anmeldung: 28.05.2003
(73) Patentinhaber: SIEMENS AKTIENGESELLSCHAFT, 80333 München (DE)
(72) Erfinder: LUBITZ, Karl, 85521 Ottobrunn (DE); SCHUH, Carsten, 85598 Baldham (DE)
(86) Internationale Anmeldenummer: PCT/DE2001/002520
(87) Internationale Veröffentlichungsnummer: WO 2002/019441

(56) Entgegenhaltungen:
- EP-A- 0 094 635
- DE-A- 3 922 504
- DE-A- 4 228 974
- DE-A- 19 850 610
- DE-A- 19 928 182
- DE-A1- 2 917 933
- DE-C- 19 814 697
- US-A- 4 438 364

## Beschreibung

Die Erfindung betrifft einen Piezoaktor mit einem piezoelektrischen Körper und mit Mitteln zum Vorspannen des piezoelektrischen Körpers, die ein erstes und ein zweites Anschlußelement zur Übertragung von Kräften auf den piezoelektrischen Körper umfassen, und mit einem Element zur Übertragung von Zug-/Druckkräften zwischen den Anschlußelementen, das wenigstens teilweise in einem lochförmig ausgebildeten Hohlraum in dem piezokeramischen Körper angeordnet ist. Weiterhin betrifft die Erfindung ein Verfahren zur Herstellung eines Piezoaktors, der einen piezoelektrischen Körper mit einem lochförmig ausgebildeten Hohlraum aufweist.

Ein derartiger Piezoaktor und ein derartiges Herstellungsverfahren sind aus der DE 198 14 697 bekannt. Darin wird ein Piezoaktor beschrieben, der einen zylinderförmig gestalteten piezokeramischen Körper umfaßt, welcher aus einer piezokeramischen Vielfachschicht in Helixstruktur besteht. Dieser piezokeramische Körper hat eine mittige Durchgangsbohrung, die als Aufnahme einer mechanischen Spannvorrichtung dient, mittels der der piezoelektrische Körper parallel zur Zylinderachse zwischen zwei als Anschlußelementen zur Übertragung von Kräften auf den piezoelektrischen Körper dienenden Abschlußplatten verspannt werden kann. Die jeweiligen Abschlußplatten sind über ein stabförmiges Halteelement miteinander verbunden, in welchem es möglich ist, eine Bohrung zum Durchleiten von Kühlflüssigkeit vorzusehen.

Bei dem Herstellungsverfahren für einen derartigen Piezoaktor wird ein Hohlzylinder aus Piezokeramik zunächst mit in der Form von ineinandergefügten Helices verlaufenden Schnittflächen versehen, in die in einem darauf folgenden Arbeitsschritt Elektrodenmaterial eingebracht wird. Als Variante dieses Herstellungsverfahrens wird vorgeschlagen, einen Zylinder aus Elektrodenmaterial zu bearbeiten, in diesen helixförmige Schnittflächen einzuarbeiten und diese dann mit piezokeramischem Material auszufüllen.

Aufgabe der Erfindung ist, einen Piezoaktor mit geringem Eigenraumbedarf zu schaffen, der bei Beaufschlagen mit einer elektrischen Spannung eine präzise definierte Auslenkung einer Abtriebseinheit bereitstellt.

Diese Aufgabe wird gelöst durch den Piezoaktor gemäß Patentanspruch 1 sowie das Verfahren gemäß Patentanspruch 8. Weitere Merkmale, Aspekte, Vorteile und Details der Erfindung ergeben sich aus den abhängigen Ansprüchen, der Beschreibung und den Zeichnungen- Vorteile, Merkmale und Details der Erfindung, die im Zusammenhang mit dem Piezoaktor beschrieben sind, gelten selbstverständlich auch für das Verfahren zur Herstellung eines Piezoaktors, und umgekehrt.

Gemäß einem ersten Aspekt der Erfindung wird ein Piezoaktor der eingangs genannten Art derart weitergebildet, daß dieser über die Mittel zum Vorspannen auf eine definierte Arbeitskurve eingestellt ist.

Auf diese Weise ist es möglich, bei gleicher Bauform des Piezoaktors diesen für unterschiedliche Anwendungen einzustellen. Es können leistungsfähige Piezoaktor-Module mit integrierter Vorspannung und geringem Einbauraumbedarf geschaffen werden. Durch die erfindungsgemäße Ausgestaltung des Piezoaktors kann je nach Ausgestaltung beispielsweise eine Hubumkehr, eine definierte Einstellung einer Arbeitskurve als Funktion der Temperatur, eine definierte Einstellung der Modul-Absolutlänge als Funktion der Temperatur (oder Temperaturkompensation), eine Kraft-Weg-Transformation und dergleichen realisiert werden. Nicht ausschließliche Beispiele hierzu werden im weiteren Verlauf der Beschreibung näher erläutert.

In Weiterbildung der Erfindung weist der Piezoaktor einen Montageanschlußabschnitt auf, der mit dem piezoelektrischen Körper starr verbunden ist. Auf diese Weise wird ein Piezoaktor mit einem sich relativ zum Montageanschlußabschnitt bewegenden Stellantrieb geschaffen.

Der piezoelektrische Körper ist als monolithisch piezokeramischer Vielschichtaktor ausgebildet. Auf diese Weise wird ein kostengünstig herstellbarer Piezoaktor geschaffen. Piezokeramische Vielschichtaktoren bestehen in der Regel aus einer Vielzahl von alternierend angeordneten Keramikschichten und metallischen Innenelektroden.

Wenigstens ein Anschlußelement ist zur Übertragung von Kräften auf den piezoelektrischen Körper als Klemmplatte ausgebildet. Auf diese Weise wird eine gute Kraftübertragung zwischen dem Anschlußelement und dem piezoelektrischen Körper ermöglicht. Die Erzielung einer bei hohen Klemmkräften ausreichend steifen Verbindung des Elements zur Übertragung von Zug-/Druckkräften mit den Klemmplatten kann vorteilhaft, jedoch nicht ausschließlich, über eine Schweißverbindung erfolgen. Gleichzeitig und/oder alternativ können die Klemmplatten sowohl hinsichtlich des Materials, als auch hinsichtlich der Plattenstärke entsprechend ausgebildet werden.

Das Element ist zur Übertragung von Kräften zwischen den Anschlußelementen in Hohlprofilform ausgebildet.

In der Hohlprofilform ist ein Medium zum Kühlen und Thermostatisieren vorhanden. Auf diese Weise ist es möglich, den Piezoaktor mit durch die Hohlprofilform geleitetem Kühlmittel zu kühlen oder zu thermostatisieren. Eine Kühlung des Piezoaktors ist insbesondere bei der hochdynamischen Ansteuerung im Großsignalbereich sinnvoll. Eine Thermostatisierung ist beispielsweise dann vorteilhaft, wenn eine exakt einstellbare und reproduzierbare Auslenkung erwünscht ist.

In der Hohlprofilform ist des Elementes zur Übertragung von Kräften zwischen den Anschlußelementen ein Abtriebselement des Piezoaktors aufgenommen. Auf diese Weise ist eine Hubumkehr der Abtriebseinheit des Piezoaktors bezüglich der Ausdehnung des piezoelektrischen Körpers im Piezoaktor erzielbar.

Bereichsweise ist zwischen den Mitteln zum Vorspannen und dem piezoelektrischen Körper ein thermisches Koppelmedium vorhanden. Durch eine zumindest bereichsweise thermische Kopplung über das Koppelmedium kann eine Wärmeentstehung, eine Wärmedosierung, eine Wärmeabfuhr und dergleichen, gezielt, gerichtet und definiert gesteuert werden. Das thermische Koppelmedium kann beispielsweise ein Kunststoff, ein Fluid oder dergleichen sein. Beispielsweise kann die wie weiter oben beschriebene Effektivität der Kühlung und/oder Thermostatisierung durch die Einbringung eines thermischen Koppelmediums zwischen dem Hohlprofil und der Aktoroberfläche noch erhöht werden.

In weiterer Ausgestaltung entspricht die thermische Ausdehnung der Mittel zum Vorspannen des piezoelektrischen Körpers der thermischen Ausdehnung des piezoelektrischen Körpers. Auf diese Weise wird durch gezielte Abstimmung der thermischen Ausdehnungskoeffizienten von piezoelektrischem Körper und den Mitteln zum Vorspannen eine definierte Hubänderung des Piezoaktors als Funktion der Temperatur einstellbar gehalten.

Die für Piezoaktoren eingesetzten Keramiken weisen in der Regel thermische Ausdehnungskoeffizienten auf, die von gebräuchlichen Metallen stark abweichen. Die thermischen Ausdehnungskoeffizienten der Mittel zum Vorspannen des piezoelektrischen Körpers können beispielsweise durch entsprechende Materialauswahl, Designanpassung (wie Stärke, Verbundaufbau und dergleichen) und dergleichen so eingestellt werden, daß die thermische Ausdehnung des gesamten Piezoaktors genau für die jeweilige Anwendung maßgeschneidert werden kann.

In weiterer Ausgestaltung kann die Steifigkeit der Mittel zum Vorspannen des piezoelektrischen Körpers auf einen gewünschten Arbeitspunkt des Piezoaktors in der Arbeitskurve abgestimmt sein. Dies kann beispielsweise, jedoch nicht ausschließlich, durch entsprechende Materialauswahl, Auswahl des Querschnitts, Strukturierung oder Aufbau der Mittel zum Vorspannen oder Teilen davon, insbesondere des Elements zur Übertragung von Zug-/Druckkräften, als Verbundkörper und dergleichen erreicht werden.

Wird beispielsweise eine bestimme Arbeitskurve im Kraft/Wegdiagramm als Funktion der Temperatur (das heißt gezielte Hubänderung als Funktion der Temperatur) gefordert, so kann dies durch gezielte Kombination der thermischen Ausdehnungskoeffizienten sowie der Steifigkeit der Mittel zum Vorspannen erzielt werden.

Vorzugsweise umfassen die Mittel zum Vorspannen des piezoelektrischen Körpers eine Tellerfeder. In weiterer Ausgestaltung können die Mittel zum Vorspannen des piezoelektrischen Körpers eine Schraubenfeder umfassen. Auf diese Weise wird durch gezielte Wahl der Federhärte ein definierter Arbeitshub und Arbeitspunkt des Piezoaktors einstellbar gehalten.

Vorteilhaft ist wenigstens ein weiteres Element zur kraftschlüssigen Verbindung von erstem und zweitem Anschlußelement zur Übertragung von Kräften auf den piezoelektrischen Körper vorgesehen. Auf diese Weise werden an den Anschlußelementen Festkörpergelenke geschaffen, die einen bogenförmigen Arbeitsweg einer Abtriebseinheit des Piezoaktors ermöglichen, wobei für den Arbeitshub eine Hebelwirkung ausgenützt werden kann.

Gemäß einem zweiten Aspekt der Erfindung wird ein Verfahren zur Herstellung eines Piezoaktors, wie vorstehend beschriebenen erfindungsgemäßen Piezoaktors, bereitgestellt, bei dem durch Laminieren piezokeramischer Schichten ein piezoelektrischer Körper hergestellt wird. In diesem wird nach dem Laminieren ein lochförmig ausgebildeter Hohlraum ausgebohrt. Nach dem Bohrvorgang wird der piezoelektrische Körper dann gesintert. Nach Fertigstellung des piezoelektrischen Körpers wird der Piezoaktor anschließend mit Mitteln zum Vorspannen des piezoelektrischen Körpers, die ein erstes und ein zweites Anschlußelement zur Übertragung von Kräften auf den piezoelektrischen Körper und ein Element zur Übertragung von Zug-/Druckkräften zwischen den Anschlußelementen, das wenigstens teilweise in einem lochförmig ausgebildeten Hohlraum in dem piezoelektrischen Körper angeordnet ist, aufweisen, vorgespannt, wobei der Piezoaktor über die Mittel zum Vorspannen auf eine definierte Arbeitskurve eingestellt wird.

Auf diese Weise wird ein Piezoaktor geschaffen, dessen piezoelektrischer Körper eine hohe elektrische Überschlags- und Kurzschlußfestigkeit aufweist. Gleichzeitig ist der Hohlraum im piezoelektrischen Körper des Piezoaktors mit äußerst präzisen Abmessungen herstellbar. Darüber hinaus ermöglicht dieses Herstellungsverfahren bei hohen Stückzahlen eine kostengünstige Produktion von Piezoaktoren.

Weitere Merkmale und Vorteile der Erfindung und der Stand der Technik sind in den Zeichnungen dargestellt und werden nachfolgend beschrieben. Es zeigen:
- Figur 1: den Schnitt eines Piezoak- tors mit einer ersten und einer zweiten Klemmplatte;
- Figuren 2 und 3: jeweils den Schnitt von mittels einer Teller- feder vorgespannten Piezoaktoren; erfindungsgemäßen Piezoaktors
- Figur 4: den Schnitt eines erfindungsgemäßen Piezoaktors mit einem in Hohlpro- filform ausgebildeten Verbindungselement zwischen Anschlußelementen zur Übertragung von Kräften auf ei- nen piezoelektrischen Körper; und
- Figuren 5, 6 und 7: jeweils einen Schnitt von Piezoaktoren mit Festkörpergelenken.

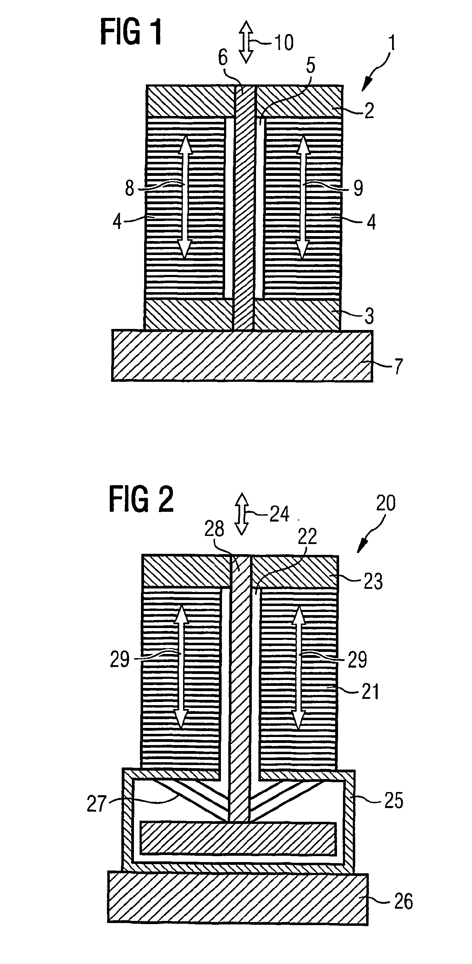

Der in der Figur 1 dargestellte Piezoaktor 1 hat eine erste und eine zweite Klemmplatte 2 und 3, die als jeweils erstes und zweites Anschlußelement zur Übertragung von Kräften auf einen piezoelektrischen Körper 4 dienen. Der piezoelektrische Körper 4 ist als monolithischer piezokeramischer Vielschichtaktor ausgebildet und weist mittig eine als lochförmig ausgebildeter Hohlraum 5 gehaltene Durchgangsbohrung mit kreisrundem Querschnitt auf. In diesem Hohlraum 5 verläuft ein Metallstab 6, der als Element zur Übertragung von Kräften zwischen der Klemmplatte 2 und der Klemmplatte 3 dient und den piezoelektrischen Körper 4 einspannt. Die Klemmplatten 2 und 3 sowie der Metallstab 6 sind dabei auf die Übertragung von hohen Klemmkräften auf den piezoelektrischen Körper ausgegelegt, etwa auf Klemmkräfte, die im Bereich von 850 N liegen.

Die Klemmplatte 3 ist auf einem Montageanschlußabschnitt 7 festgelegt, mittels der der Piezoaktor 1 an einem vorgesehenen Einsatzort befestigt wird. Über nicht weiter dargestellte Anschlüsse zur Zufuhr von elektrischer Spannung kann der Piezoaktor 1 mit einem elektrischen Signal beaufschlagt werden, was eine Ausdehnung oder Kontraktion seines piezoelektrischen Körpers 4 entsprechend einer mit den Doppelpfeilen 8 und 9 angedeuteten Bewegung zur Folge hat. Eine derartige Bewegung des piezoelektrischen Körpers 4 überträgt sich auf die Klemmplatte 2, welche eine Abtriebseinheit für eine mittels des Doppelpfeiles 10 angedeutete Abtriebsbewegung darstellt.

Die thermische Ausdehnung des Metallstabes 6 ist dabei an die thermische Ausdehnung des piezoelektrischen Körpers 4 angepaßt. Mit dieser Maßnahme kann zum einen eine temperaturunabhängige Arbeitskurve des Piezoaktors 1 erzielt werden, indem die thermische Ausdehnung des piezoelektrischen Körpers 4 die thermische Ausdehnung von Metallstab 6 und der Klemmplatten 2 und 3 kompensiert. Alternativ zu dieser Maßnahme ist es aber auch möglich, ein definiertes Verhältnis der thermischen Ausdehnung von Metallstab 6 und dem piezoelektrischen Körper 4 zu wählen, so daß eine definierte Veränderung der Arbeitskurve des Piezoaktors 1 als Funktion der Temperatur erzielt werden kann.

Neben der Wahl der thermischen Ausdehnung von Metallstab 6 und piezoelektrischem Körper 4 kann die Arbeitskurve des Piezoaktors 1 auch durch Einstellen der zwischen den Klemmplatten lastenden mechanischen Spannung festgelegt werden.

Dies kann beispielsweise durch geeignete Wahl der geometrischen Abmessungen von Metallstab 6, Klemmplatte 2, 3 und dem piezoelektrischen Körper vor einer Endmontage des Piezoaktors 1 erzielt werden. Zum Verspannen der Klemmplatten 2, 3 über den Metallstab 6 können aber auch geeignete Spanngewindeeinheiten oder entsprechende Mittel an den jeweiligen Bauteilen vorgesehen sein.

Um eine gleichmäßige Krafteinleitung über die gesamte Stirnfläche des piezoelektrischen Körpers 4 zu ermöglichen, sind die Klemmplatten 2 und 3 vorteilhafter Weise gewölbt gehalten. Besonders hohe Kräfte können zwischen Metallstab 6 und den Klemmplatten 2 und 3 übertragen werden, wenn Metallstab 6 und die Klemmplatten 2 und 3 mittels Schweißverbindungen verbunden sind.

Bei dem in der Figur 2 dargestellten Piezoaktor 20 ist ein piezoelektrischer Körper 21, der mit einer als lochförmiger Hohlraum 22 gehaltenen Durchgangsbohrung versehen ist, einerseits von einer als Abtriebseinheit dienenden Klemmplatte 23 gehalten. Andererseits ist der piezoelektrische Körper 21 mit einem in Hohlprofilform gestalteten Basiselement 25 verbunden, welches an einem Montageanschlußabschnitt 26 festgelegt ist.

Der piezoelektrische Körper 21 wird zwischen die Klemmplatte 23 und dem Basiselement 25 in Hohlprofilform über die Kraft einer Tellerfeder 27 eingespannt, deren Federkraft durch einen Metallstab 28 übertragen wird. Indem die Spannkraft der Tellerfeder 27 geeignet gewählt wird, ist es möglich, aufgrund einer passenden Vorspannung des piezoelektrischen Körpers 21 eine gewünschte Arbeitskurve des Piezoaktors 20 einzustellen.

Bei Beaufschlagung des piezoelektrischen Körpers 21 mit Spannung über nicht weiter dargestellte elektrische Anschlüsse wird eine Ausdehnungs- beziehungsweise Kontraktionsbewegung dessen entsprechend der mit den Doppelpfeilen 29 angedeuteten Bewegung hervorgerufen. Diese Ausdehnung beziehungsweise Kontraktion des piezoelektrischen Körpers 21 überträgt sich auf die als Abtriebseinheit dienende Klemmplatte 23, welche sich dann entsprechend dem Doppelpfeil 24 bewegt.

Günstigerweise sind wiederum die thermische Ausdehnung von Metallstab 28, der Tellerfeder 27 und dem piezoelektrischen Körper 21 aneinander angepaßt.

Durch geeignete Wahl der Federhärte von Tellerfeder 27 und das Festlegen einer entsprechenden Vorspannkraft für den piezoelektrischen Körper 21 ist es wie bei dem anhand von Figur 1 beschriebenen Piezoaktor 1 möglich, eine Arbeitskurve definiert einzustellen.

Anstelle der Tellerfeder 27 kann auch eine Schraubenfeder oder ein anderes geeignetes Federmittel eingesetzt werden.

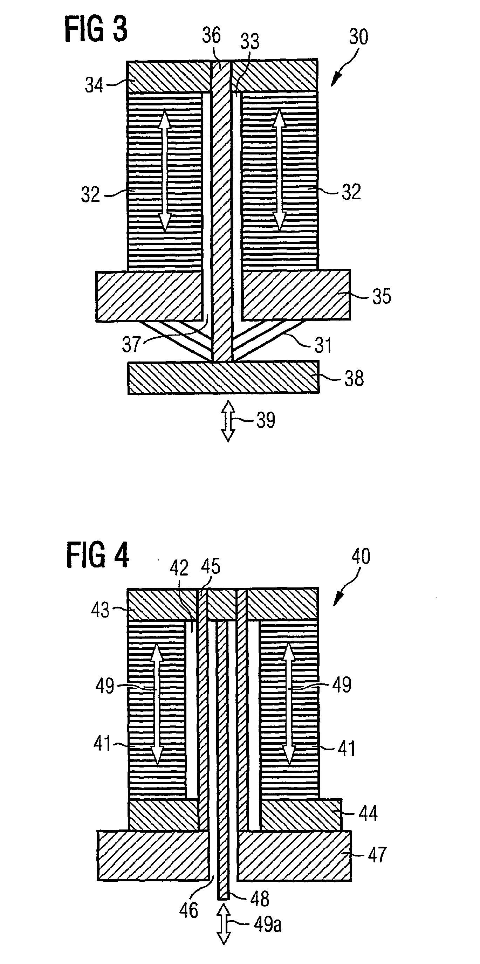

Das Funktionsprinzip des in der Figur 3 dargestellten Piezoaktors 30 entspricht prinzipiell demjenigen von Piezoaktor 20 aus Figur 2. Wiederum hat der Piezoaktor 30 eine Tellerfeder 31, um einen piezoelektrischen Körper 32 mit einer als lochförmiger Hohlraum 33 ausgebildeten Durchgangsbohrung zwischen einer Klemmplatte 34 und einem Montageanschlußabschnitt 35 über einen Metallstab 36 zu verspannen. In dem Montageanschlußabschnitt 35 ist eine Arbeitsöffnung 37 vorgesehen, durch die der Metallstab 36 hindurchragt, um an einer Abtriebseinheit 38 eine entsprechend dem Doppelpfeil 39 verlaufende Abtriebsbewegung bereitzustellen. Die Richtung dieser Abtriebsbewegung erfolgt dabei bezüglich dem in der Figur 2 dargestellten Piezoaktor 20 mit umgekehrtem Hub, das heißt bei Ausdehnung des piezoelektrischen Körpers 32 bewegt sich der Abtriebsbereich auf den Montageanschlußabschnitt 35 zu, bei Kontraktion dagegen von diesem weg.

Demgegenüber bewirkt eine Ausdehnung des piezoelektrischen Körpers 21 im Piezoaktor 20 aus Figur 2 eine Hubbewegung, welche die als Antriebseinrichtung dienende Klemmplatte 23 von dem Montageanschlußabschnitt wegführt, und umgekehrt bei Kontraktion des piezoelektrischen Körpers 21 eine auf den Montageanschlußabschnitt 26 gerichtete Bewegung hervorruft.

Es sei bemerkt, daß wie der Piezoaktor 20 aus Figur 2, der in der Figur 3 dargestellte Piezoaktor 30 anstelle mit einer Tellerfeder auch mit Schraubenfedern oder einem anderen geeigneten Federmittel ausgeführt werden kann. Vorteilhafterweise sind wie bei den in Figur 1 und Figur 2 dargestellten Piezoaktoren wiederum die thermische Ausdehnung der Bauelemente des Piezoaktors 30 aufeinander abgestimmt, um entweder eine temperaturunabhängige Arbeitskurve des Piezoaktors zu ermöglichen oder einen Piezoaktor zu schaffen, dessen Arbeitskurve sich in definierter Weise als Funktion der Temperatur ändert. Ferner kann entsprechend den Ausführungen zu den Figuren 1 und 2 durch geeignete Vorspannung des piezoelektrischen Körpers 32 mit der Klemmplatte 34, dem Montageanschlußabschnitt 35, der Tellerfeder 31 und dem Metallstab 36 die Arbeitskurve des Piezoaktors definiert eingestellt werden.

Die Figur 4 zeigt einen erfindungsgemäßen Piezoaktor 40 mit piezoelektrischem Körper 41, welcher wiederum eine als lochförmig ausgebildeter Hohlraum 42 gehaltene Durchgangsbohrung aufweist und zwischen einer ersten Klemmplatte 43 und einer zweiten Klemmplatte 44 mit einem in Hohlprofilform gehaltenen Stab 45 verspannt ist. Mit der zweiten Klemmplatte 44 ist der piezoelektrische Körper 41 auf einem mit einer Durchgangsöffnung 46 versehenen Montageanschlußabschnitt 47 festgelegt. Als Abtriebeinheit ist an dem Piezoaktor 40 eine Abtriebsstange 48 vorhanden, die in dem in Hohlprofilform gehaltenen Stab 45 verläuft, durch die Durchgangsöffnung 46 im Montageanschlußabschnitt 47 hindurchragt und im Bereich der ersten Klemmplatte 43 festgelegt ist. Bei definierter Ausdehnung beziehungsweise Kontraktion des piezoelektrischen Körpers 41 entsprechend einer mittels der Doppelpfeile 49 angedeuteten Bewegung wird eine Abtriebsbewegung der Abtriebsstange 48 hin zu dem Montageanschlußabschnitt 47 beziehungsweise von diesem weg entsprechend dem Doppelpfeil 49a hervorgerufen.

Um einer Aufwärmung des Piezoaktors 40 beim Betrieb entgegenzuwirken, wird in der Hohlprofilform des Stabes 45 eine Kühlflüssigkeit geführt. Damit erfolgt dann eine Regelung der Temperatur des Piezoaktors, um auch bei hochdynamischer Ansteuerung im Großsignalbereich exakt festlegbare und reproduzierbare Auslenkungen zu ermöglichen.

Wie bei dem in der Figur 3 dargestellten Piezoaktor wird aber eine Hubumkehr der Abtriebseinheit von Piezoaktor 40 im Vergleich zu den Abtriebseinheiten der Piezoaktoren aus den Figuren 1 und 2 erzielt.

Was die Wahl der thermischen Ausdehnung der verwendeten Bauteile und die mechanische Vorspannung des piezoelektrischen Körpers 41 betrifft, so sei auf die Erläuterungen zu den Figuren 1 bis 3 verwiesen.

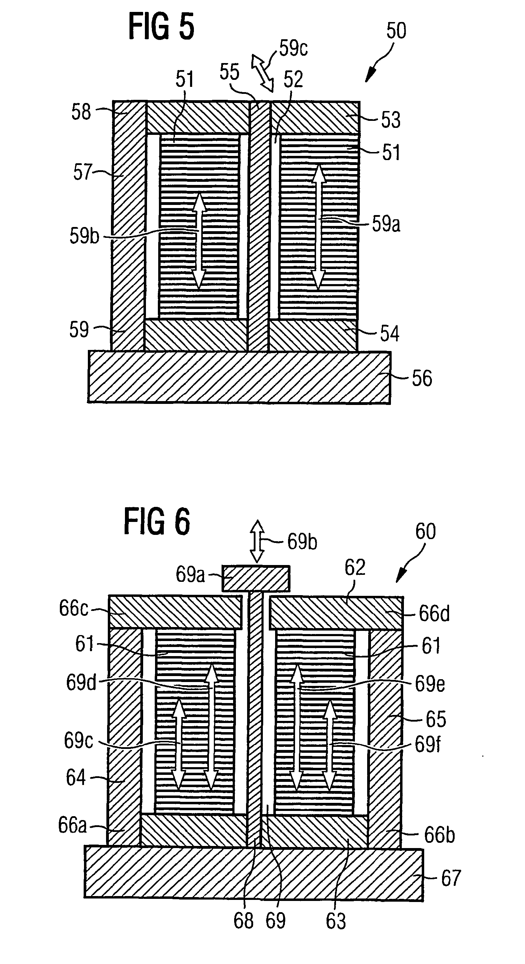

Die Figur 5 zeigt einen Piezoaktor 50, der wie der zuvor beschriebene Piezoaktor einen piezoelektrischen Körper 51 mit einer Durchgangsbohrung aufweist, die als lochförmig ausgebildeter Hohlraum 52 gehalten ist. Der piezoelektrische Körper 51 ist zwischen einer ersten Klemmplatte 53 und einer zweiten Klemmplatte 54 über einen Stab 55 verspannt und auf einem Montageanschlußabschnitt 56 festgelegt. Darüber hinaus sind die erste Klemmplatte 53 und die zweite Klemmplatte 54 über einen Anschlußarm 57 verbunden, der in Bereichen 58 und 59 als Festkörpergelenk wirkt. Bei Beaufschlagen des Piezoaktors 50 mit elektrischer Spannung über nicht weiter dargestellte elektrische Anschlüsse wird eine Kontraktion, beziehungsweise Ausdehnung des piezoelektrischen Körpers 51 hervorgerufen, die jedoch, wie mittels der Doppelpfeile 59a und 59b angedeutet ist, auf Grund der Festkörpergelenke in den Bereichen 58 und 59 asymmetrisch verläuft, so daß an der als Abtriebseinheit dienenden ersten Klemmplatte 53 eine, wie mittels des Doppelpfeiles 59c angedeutet, bogenförmig verlaufende Abtriebsbewegung bereitgestellt wird.

Was die Wahl der thermischen Ausdehnung der verwendeten Bauteile und die mechanische Vorspannung des piezoelektrischen Körpers 41 betrifft, so sei auf die Erläuterungen zu den Figuren 1 bis 3 verwiesen.

Der Piezoaktor 60 in Figur 6 enthält einen piezoelektrischen Körper 61, der mittels einer ersten Klemmplatte 62, einer zweiten Klemmplatte 63 und mittels außerhalb des piezoelektrischen Körpers 61 verlaufenden Anschlußarmen 64 und 65 unter Bildung von Festkörpergelenken 66a, 66b, 66c und 66d mechanisch verspannt ist. Über die zweite Klemmplatte 63 ist der piezoelektrische Körper 61 auf einem Montageanschlußabschnitt 67 festgelegt. Im Piezoaktor 60 ist ein Stab 68 vorgesehen, der in einem als Durchgangsbohrung ausgebildeten lochförmigen Hohlraum 69 im piezoelektrischen Körper 61 verläuft und in einem als Abtriebseinheit dienenden Bereich 69a eine Abtriebsbewegung bereitstellt. Bei Beaufschlagen des Piezoaktors 60 mit einer elektrischen Spannung wird auf Grund der Verspannung des piezoelektrischen Körpers 61 zwischen der ersten Klemmplatte 62 und der zweiten Klemmplatte 63 eine ungleichmäßige Ausdehnung entsprechend den Pfeilen 69c, 69d, 69e und 69f hervorgerufen, was eine Wölbung der ersten Klemmplatte 62 bewirkt. Dies hat eine Bewegung des Stabes 68 im Bereich 69a in einer Weise zur Folge, wie dies mittels des Doppelpfeiles 69b angedeutet ist.

Für die Bewegung des als Abtriebseinheit dienenden Bereiches 69a wird also eine Hebelwirkung der gewählten ersten Klemmplatte 62 auf den Bereich 69a ausgenutzt. Diese Hebelwirkung ermöglicht eine Übersetzung der Ausdehnungs- beziehungsweise Kontraktionsbewegung des piezoelektrischen Körpers 61, d.h. relativ zum Hub der Ausdehnungs- beziehungsweise Kontraktionsbewegung des piezoelektrischen Körpers 61 ist der Hub des als Abtriebseinheit dienenden Bereiches 69a vergrößert.

Was die Wahl der thermischen Ausdehnung der verwendeten Bauteile und die mechanische Vorspannung des piezoelektrischen Körpers angeht, so sei auf die Erläuterungen zu den Figuren 1 bis 3 verwiesen.

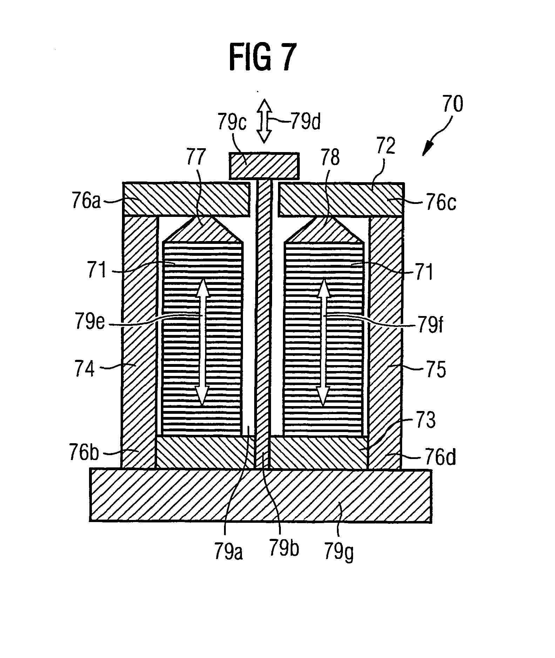

Die Figur 7 zeigt einen Piezoaktor 70, dessen Wirkungsweise derjenigen des Piezoaktors 60 aus der Figur 6 entspricht. Der Piezoaktor 70 enthält einen piezoelektrischen Körper 71, der zwischen einer ersten Klemmplatte 72 und einer zweiten Klemmplatte 73 über seitliche Klemmarme 74 und 75 unter Bildung von Festkörpergelenken 76a, 76b, 76c und 76d eingefaßt und verspannt ist. In den Bereichen 77 und 78 ist der piezoelektrische Körper 71 durch eine ringförmig ausgebildete Anschlußkappe mit trapezförmigem Querschnitt gehalten, um bei lediglich geringer Berührungsfläche der Anschlußkappe mit der ersten Klemmplatte 72 eine symmetrische Einleitung der Klemmkraft in den piezoelektrischen Körper 71 zu gewährleisten. Im piezoelektrischen Körper 71 ist ein als lochförmig ausgebildete Durchgangsbohrung gehaltener Hohlraum 79a vorgesehen, in dem ein als Abtriebseinheit dienender Stab 79b aufgenommen ist. Wird der Piezoaktor 70 über nicht weiter gezeigte elektrische Anschlüsse mit einem elektrischen Spannungssignal beaufschlagt, was eine Ausdehnung, beziehungsweise Kontraktion, des piezoelektrischen Körpers 71 wie mit den Doppelpfeilen 79e und 79f angedeutet relativ zum Montageanschlußabschnitt 79g hervorruft, so führt der Stab 79b in einem Bereich 79c eine mittels des Doppelpfeiles 79d angedeutete Abtriebsbewegung aus.

Was die Wahl der thermischen Ausdehnung der verwendeten Bauteile und die mechanische Vorspannung des piezoeletrischen Körpers angeht, so sei auf die Erläuterungen zu den Figuren 1 bis 3 verwiesen.

Selbstverständlich ist es möglich, das Abtriebskonzept der Piezoaktoren aus den Figuren 6 und 7 dahingehend zu modifizieren, daß ein Abtrieb mit Hubumkehr bezüglich der Ausdehnung und Kontraktion des piezoelektrischen Körpers erfolgt, wie dies für die Piezoaktoren 30 und 40 anhand der Figuren 3 und 4 erläutert wurde.

Der piezoelektrische Körper der in den Figuren 1 bis 7 dargestellten Piezoaktoren kann in Zylinderform gehalten sein, aber auch trapezförmig, quaderförmig oder mit ellipsoidalem Querschnitt ausgeführt werden. Anstatt die durch ihn tretende Durchgangsbohrung kreisrund zu halten, ist es auch möglich, einen Querschnitt in Form eines Vierecks, etwa einen quadratischen Querschnitt, vorzusehen. Allgemein wird die Verspannung des piezoelektrischen Körpers so gewählt, daß der Piezoaktor eine für den Einsatz günstige Arbeitskurve hat. Hierfür sind die elastischen und thermoelastischen Eigenschaften der verwendeten Materialien, insbesondere von piezoelektrischen Körpern und den Klemmvorrichtungen aufeinander abgestimmt.

Indem für einen Piezoaktor Mittel zur Kühlung vorgesehen werden, ist es möglich, Temperatureinflüsse auf eine bereitgestellte Abtriebsbewegung nahezu auszuschließen. Besonders präzise Abtriebsbewegungen lassen sich mit einem Piezoaktor erzielen, der bei geregelter Temperatur betrieben wird.

Der piezoelektrische Körper in den in den Figuren 1 bis 7 dargestellten Piezoaktoren ist als Sinterkeramik ausgeführt wobei der lochförmig ausgebildete Hohlraum in ihm mittels Bohren geschaffen wird. Grundsätzlich besteht hier die Gefahr, daß auf dem piezoelektrischen Körper sich befindende Isolationsschichten im Bereich der Klemmplatten geschädigt werden, was nicht zuletzt auch eine inhomogene Verteilung der Klemmkräfte zur Folge haben kann. Außerdem ist damit zu rechnen, daß bei dem Bohrvorgang im Bereich des lochförmig ausgebildeten Hohlraumes Material von sich dort befindenden Innenelektroden massiv über die Innenlochoberfläche verschmiert wird. Dies kann bei einem späteren elektrischen Betrieb des piezoelektrischen Körpers zum Auftreten von Überschlägen und Kurzschlüssen führen.

Werden dagegen Vielschichtbauelemente als piezoelektrische Körper eingesetzt, so muß bei ihrer Bearbeitung auf Grund deren geringer Festigkeit gegenüber Delaminationsrissen mit geringen Vorschubgeschwindigkeiten gearbeitet werden, und es besteht die Gefahr, daß bei einem ungenügenden Abtransport von Spülwasser und Bohrstaub mechanische Spannungsüberhöhungen auftreten, die eine Zerstörung des Bauteils durch Rißbildung zur Folge haben.

Der piezoelektrischen Körpe in dem in den Figuren 1 bis 7 dargestellten Piezoaktor wird aus einem Piezostack gefertigt, der noch im Grünzustand, d.h. gleich nach dem Laminieren des Stacks mechanisch bearbeitet wird. Die Durchgangsbohrung in den jeweiligen piezoelektrischen Körpern kann dabei mit normalen Spiralbohrern ausgeführt werden, wobei auf eine Kühlung und Schmierung des Bohrers aufgrund der noch gegebenen Weichheit des Materials verzichtet werden kann. Wegen der Weichheit des Materials kann auch der erforderliche Druck auf den Bohrer zur Erzielung einer ausreichenden Vorschubgeschwindigkeit gering gehalten werden. Werden außerdem beim Bohrvorgang Bohrunterlagen verwendet, entstehen keinerlei Ausbrüche. Zwar kommt es durch den Bohrvorgang auch bei diesen piezoelektrischen Körpern zu einer Verschmierung von metallischen Innenelektroden, die beispielsweise als Ag/Pd-Innenelektroden gehalten sein können. Bei einer nachfolgenden Sinterung des Bauteils diffundieren jedoch diese Verschmierungen, insbesondere der Silberbestandteil in das Bauteil und werden unter Ausbildung einer As-Fired-Sinteroberfläche eliminiert. Das gesinterte Bauteil kann dann ohne jeglichen Nachbearbeitungsaufwand im Bereich der Durchgangsbohrung weiter bearbeitet werden. Eine ausreichende Überschlags- und Kurzschlußfestigkeit der Oberfläche in diesem Bereich ist dann direkt gegeben. Anstatt die Durchgangsbohrung mittels eines Bohrers herzustellen, besteht prinzipiell auch die Möglichkeit, den piezoelektrischen Rohkörper mittels Drehen, Fräsen und ähnlichen Methoden zu bearbeiten. Insbesondere ermöglicht dieses Grünbearbeitungsverfahren eine wirtschaftliche Herstellung von sehr großen Stückzahlen von Rohlingen eines piezoelektrischen Körpers, der sich zum Einsatz in einem Piezoaktor, wie er in den Figuren 1 bis 7 dargestellt ist, hervorragend eignet.

## Patentansprüche

1. Piezoaktor (40),
- mit einem piezoelektrischen Körper in Form eines monolithischen piezokeramischen Vielschichtaktors (41) und
- mit Mitteln (43, 44, 45) zum Vorspannen des piezoelektrischen Körpers, die ein erstes (43) und ein zweites (44) Anschlußelement zur Übertragung von Kräften auf den piezoelektrischen Körper (41) umfassen, wobei
- die Mittel zum Vorspannen ein Element (45)
zur Übertragung von Zug-/Druckkräften zwischen den Anschlußelementen aufweisen, das wenigstens teilweise in einem lochförmig ausgebildeten Hohlraum (42) in dem piezoelektrischen Körper angeordnet ist,
- der Piezoaktor über die Mittel zum Vorspannen auf eine definierte Arbeitskurve eingestellt ist,
- die definierte Arbeitskurve einen hochdynamischen Betrieb des Piezoaktors im Großsignalbereich betrifft,
- zum Einstellen der definierten Arbeitskurve eine thermische Ausdehnung des piezoelektrischen Körpers und eine thermische Ausdehnung der Mittel zum Vorspannen aneinander angepasst sind,
- das Element zur Übertragung von Kräften zwischen den Anschlußelementen in Hohlprofilform (45) ausgebildet ist,
- wenigstens ein Anschlußelement zur Übertragung von Kräften auf den piezoelektrischen Körper (41) als Klemmplatte (43) ausgebildet ist und
- in der Hohlprofilform (45) ein Medium zum Thermostatisieren vorhanden ist, das ein Medium zum Kühlen ist,
**dadurch gekennzeichnet, daß** in der Hohlprofilform (45) des Elementes zur Übertragung von Kräften zwischen den Anschlußelementen ein Abtriebselement (48) des Piezoaktors (40) aufgenommen ist, wobei zumindest bereichsweise zwischen den Mitteln zum Vorspannen (43, 44, 45)
und dem piezoelektrischen Körper (41) ein thermisches Koppelmedium angeordnet ist.

2. Piezoaktor gemäß Anspruch 1, **dadurch gekennzeichnet, daß** er einen Montageanschlußabschnitt (47) aufweist, mit dem der piezoelektrische Körper (41) starr verbunden ist.

3. Piezoaktor gemäß einem der Ansprüche 1 oder 2,
**dadurch gekennzeichnet, daß** die thermische Ausdehnung der Mittel zum Vorspannen (43, 44, 45) des piezoelektrischen Körpers (41) der thermischen Ausdehnung des piezoelektrischen Körpers entspricht.

4. Piezoaktor gemäß einem der Ansprüche 1 bis 3,
**dadurch gekennzeichnet, daß** die Steifigkeit der Mittel zum Vorspannen (43, 44, 45) des piezoelektrischen Körpers (41) auf einen gewünschten Arbeitspunkt des Piezoaktors in der Arbeitskurve abgestimmt ist.

5. Piezoaktor gemäß einem der Ansprüche 1 bis 4,
**dadurch gekennzeichnet, daß** die Mittel zum Vorspannen des piezoelektrischen Körpers eine Tellerfeder
umfassen.

6. Piezoaktor gemäß einem der Ansprüche 1 bis 5,
**dadurch gekennzeichnet, daß** die Mittel zum Vorspannen des piezoelektrischen Körpers eine Schraubenfeder umfassen.

7. Piezoaktor gemäß einem der Ansprüche 1 bis 6,
**dadurch gekennzeichnet, daß** wenigstens ein weiteres Element zur kraftschlüssigen Verbindung von erstem und zweitem Anschlußelement zur Übertragung von Kräften auf den piezokelektrischen Körper angeordnet ist.

8. Verfahren zur Herstellung eines Piezoaktors (40) gemäß einem der Ansprüche 1 bis 7 der einen piezoelektrischen Körper (41) mit einem lochförmig ausgebildeten Hohlraum (42) aufweist, bei dem
- mittels Laminieren piezokeramischer Schichten ein laminierter Grünkörper hergestellt wird,
- nach dem Laminieren in dem laminierten Grünkörper der Hohlraum (42) ausgebohrt wird;
- nach dem Bohrvorgang ein Sintern des laminierten Grünkörpers erfolgt, wobei der piezoelektrische Körper (41) entsteht; und
- der Piezoaktor anschließend mit Mitteln (43, 44, 45)
zum Vorspannen des piezoelektrischen Körpers, die ein erstes (43) und ein zweites (44) Anschlußelement zur Übertragung von Kräften auf den piezoelektrischen Körper (41) und ein Element (45) zur Übertragung von Zug-/Druckkräften zwischen den Anschlußelementen, das wenigstens teilweise in einem lochförmig ausgebildeten Hohlraum (42) in dem piezoelektrischen Körper angeordnet ist, aufweisen, vorgespannt wird, wobei der Piezoaktor über die Mittel zum Vorspannen auf eine definierte Arbeitskurve eingestellt wird.

## Claims

1. Piezoactuator (40)
- with a piezoelectric body in the form of a monolithic piezoceramic multilayer actuator (41) and
- with means (43, 44, 45) for pre-tensioning the piezoelectric body, comprising a first (43) and a second (44) connecting element for transferring forces to the piezoelectric body (41); with
- the pre-tensioning means having an element (45) for transferring tensile/pressure forces between the connecting elements, said element being at least partially disposed in a gap (42) shaped in the form of a bore in the piezoelectric body,
- the piezoactuator being set to a defined working curve using the pre-tensioning means,
- the defined working curve relating to a highly dynamic operation of the piezoactuator in the large signal range,
- to set the defined working curve, thermal expansion of the piezoelectric body and thermal expansion of the pretensioning means are matched to one another,
- the element for transferring forces between the connecting elements is embodied in a hollow profile form (45),
- at least one connecting element for transferring forces to the piezoelectric body (41) is embodied as a clamping plate (43) and
- a thermostatting medium exists in the hollow profile form (45), which is a medium for cooling,
**characterized in that**
- a drive element (48) of the piezoactuator (40) is received in the hollow profile form (45) of the element for transferring forces between the connecting elements, with
- a thermal coupling medium being arranged at least in regions between pretensioning means (43, 44, 45) and the piezoelectric body (41).

2. Piezoactuator according to claim 1, **characterised in that** the piezoactuator has a mounting pad section (47) with which the piezoelectric body (41) is rigidly connected.

3. Piezoactuator according to one of claims 1 or 2, **characterised in that** the thermal expansion of the pre-tensioning means (43, 44, 45) of the piezoelectric body (41) corresponds to the thermal expansion of the piezoelectric body.

4. Piezoactuator according to one of claims 1 to 3, **characterised in that** the rigidity of the pre-tensioning means (43, 44, 45) of the piezoelectric body (41) is matched to a required working point of the piezoactuator in the working curve.

5. Piezoactuator according to one of claims 1 to 4, **characterised in that** the pre-tensioning means of the piezoelectric body comprise a cup spring.

6. Piezoactuator according to one of claims 1 to 5, **characterised in that** the pre-tensioning means of the piezoelectric body comprise a helical spring.

7. Piezoactuator according to one of claims 1 to 6, **characterised in that** there is provided at least one further element for frictionally connecting in the first (53, 62, 72) and second (54, 63, 73) connecting element for transferring forces to the piezoelectric body (51, 61, 71).

8. Method for producing a piezoactuator (40), according to one of claims 1 to 7, having a piezoelectric body (41) with a gap (42) shaped in the form of a bore, wherein
- a laminated base body is produced by the lamination of piezoceramic layers,
- the gap (42) is drilled in the laminated base body (4, 21, 32, 41, 51, 61, 71 after lamination;
- the laminated base body (41) is sintered after the drilling process; with the piezoelectric body (41) being produced and
- the piezoactuator is subsequently pre-tensioned using pretensioning means (43, 44, 45) for the piezoelectric body, said means having a first (43) and a second (44) connecting element for transferring forces to the piezoelectric body (41) and an element (45) for transferring tensile/pressure forces between the connecting elements, said element being disposed at least partially in a gap (42) shaped in the form of a bore in the piezoelectric body, the piezoactuator being set to a defined working curve using the pre-tensioning elements.

## Revendications

1. Piézoactionneur comportant :
- un corps piézoélectrique en forme d'actionneur multicouche piézocéramique monolithique (41) et
- des moyens (43, 44, 45) pour précontraindre le corps piézoélectrique, lesquels comprennent un premier (43) et un deuxième (44) élément de raccordement pour transmettre des forces au corps piézoélectrique(41),
- les moyens de précontrainte comportant un élément (45) pour la transmission de forces de traction / de pression entre les éléments de raccordement, lequel est situé au moins en partie dans une cavité (42) du corps piézoélectrique configurée en forme de trou ;
- le piézoactionneur étant réglé sur une courbe de travail définie par l'intermédiaire des moyens de précontrainte ;
- la courbe de travail définie concernant un fonctionnement hautement dynamique du piézoactionneur dans la plage des signaux forts ;
- pour le réglage de la courbe de travail définie, une dilatation thermique du corps piézoélectrique et une dilatation thermique des moyens de précontrainte étant adaptées l'une à l'autre ;
- l'élément de transmission de forces entre les éléments de raccordement étant configuré en forme de profilé creux (45),
- au moins un élément de raccordement pour transmettre des forces au corps piézoélectrique (41) étant réalisé sous la forme d'une plaque de serrage (43) et
- un fluide de thermostatisation étant prévu dans la forme de
profilé creux (45), lequel est un fluide de refroidissement, **caractérisé en ce que** un élément de sortie (48) du piézoactionneur (40) est logé dans la forme de profilé creux (45) de l'élément pour la transmission de forces entre les éléments de raccordement, un fluide de couplage thermique étant situé, au moins par endroits, entre les moyens de précontrainte (43, 44, 45) et le corps piézoélectrique (41).

2. Piézoactionneur selon la revendication 1, **caractérisé en ce qu'**il comporte une partie de raccordement de montage (47) dont le corps piézoélectrique (41) est solidaire.

3. Piézoactionneur selon l'une des revendications 1 ou 2, **caractérisé en ce que** la dilatation thermique des moyens de précontrainte (43, 44, 45) du corps piézoélectrique (41) correspond à la dilatation thermique du corps piézoélectrique.

4. Piézoactionneur selon l'une des revendications 1 à 3, **caractérisé en ce que** la rigidité des moyens de précontrainte (43, 44, 45) du corps piézoélectrique (41) est accordée à un point de travail souhaité du piézoactionneur sur la courbe de travail.

5. Piézoactionneur selon l'une des revendications 1 à 4, **caractérisé en ce que** les moyens de précontrainte du corps piézoélectrique comprennent une rondelle-ressort.

6. Piézoactionneur selon l'une des revendications 1 à 5, **caractérisé en ce que** les moyens de précontrainte du corps piézoélectrique comprennent un ressort spiral.

7. Piézoactionneur selon l'une des revendications 1 à 6, **caractérisé en ce qu'**au moins un autre élément est agencé pour établir une liaison par adhérence entre le premier et le deuxième élément de raccordement pour la transmission de forces au corps piézoélectrique.

8. Procédé de fabrication d'un piézoactionneur (40) selon l'une des revendications 1 à 7 qui comporte un corps piézoélectrique (41) avec une cavité (42) configurée en forme de trou, dans lequel :
- un compact vert laminé est réalisé par laminage de couches piézocéramiques ;
- après le laminage, la cavité (42) est réalisée par alésage dans le compact vert laminé ;
- après l'opération d'alésage, il y a frittage du compact vert laminé, le corps piézoélectrique (41) se créant, et
- le piézoactionneur étant ensuite précontraint par des moyens (43, 44, 45) de précontrainte du corps piézoélectrique, lesquels comportent un premier (43) et un deuxième (44) élément de raccordement pour la transmission de forces au corps piézoélectrique (41) et un élément (45) pour la transmission de forces de traction / de pression entre les éléments de raccordement, lequel est situé au moins en partie dans une cavité configurée en forme de trou (42), dans le corps piézoélectrique le piézoactionneur étant réglé sur une courbe de travail définie par l'intermédiaire des moyens de précontrainte.
